# EUROPEAN PATENT APPLICATION

(11) **EP 2 551 691 A1**
(43) Date of publication of application: **30.01.2013**
(21) Application number: 11192114.4
(22) Date of filing: 06.12.2011
(51) Int. Cl.: G01R 33/00, G01R 33/07, G01R 33/02

(54) **A method for manufacturing a Hall sensor assembly and a Hall sensor assembly**

(30) Priority: 27.07.2011 EP 11175607
(71) Applicant: Paul Scherrer Institut, 5232 Villigen PSI (CH)
(72) Inventor: Sanfilippo, Stephane, 6410 Goldau (CH); Vrankovic, Vjeran, 5303 Würenlingen (CH)
(74) Representative: Fischer, Michael

(57) **Abstract**

An assembly (2) of Hall sensors (6) provides the advantages :
■ the averaged values of all three field components are assigned to the same point in space, at the centre (4) of the Hall sensor (6), thus allowing for instantaneous measurements of the full field vector;
■ with the appropriate electrical connections of the Hall elements from opposing surfaces of each pair, the undesired planar Hall effect can be practically cancelled out.

## Description

The present invention relates to a method for manufacturing a Hall sensor assembly and a Hall sensor assembly.

Hall sensors are known as sensors to measure the strength of a magnetic field by measuring a voltage. Different from inductive measurements, a Hall sensor can also sense DC magnetic fields since the voltage output of a Hall sensor under current is proportional to the current and the strength of the magnetic field. Three-Dimensional Magnetic Field Sensors are disclosed in the British Patent Application GB 2 159 278 A. Hall sensors are used in a broad variety of scientific and commercial applications, such in position sensing, in proton therapy, in NMR, in synchrotron and other particle accelerators or electromagnetic beam lines and magnets and so on.

It is well known in the art to measure the strength of the magnetic field using Hall sensors. Nevertheless, it is still a challenge to measure the strength of the magnetic field in a 3D approach with an accuracy better than 1%. It is therefore the goal of the present invention to improve the known state of the art, in particular the readiness to measure a spatial 3d distribution at the same time at the same place.

With respect to the Hall sensor assembly, this goal is achieved according to the present invention by a Hall sensor assembly, comprising a number of Hall sensors, each Hall sensor being disposed on a non-conducting, non-magnetic support part, wherein the support parts are formed to support the formation of three groups of Hall sensors, each group covering the measurement of the magnetic field for one of the three Cartesian directions wherein the three groups of Hall sensors, and in particular their Hall sensor active areas, are disposed adjacent to each other in order to share a common Hall sensor active volume.

With respect to the method for manufacturing a Hall sensor assembly, this goal is achieved according to the present invention by the following method steps:
a) depositing a Hall sensor active area on a substrate;
b) contacting the Hall sensor active area with four contact lines being hosted on the sensor substrate;
c) mounting the sensor substrate to a support part;
d) optionally smoothing the passage from the sensor substrate and the support part;
e) extending the four contact line (8 to 14) along the support part (18);
f) assembling a number of support parts manufactured according to the step a) to e) in order to form three groups of Hall sensors, each group covering the measurement of the magnetic field for one of the three Cartesian directions wherein the three groups of Hall sensors are disposed adjacent to each other in order to share a common Hall sensor active volume.

Therefore, the present invention provides for a Hall sensor assembly as a miniature Hall effect 3D magnetic field sensor because the Hall sensor active areas are all concentrated in the Hall sensor active volume wherein each of the three groups of sensors is dedicated to one determined axis of the Cartesian system. Due to the small design of Hall sensor active areas in the range of micrometers (i.e. 50 µm, each group which can comprise one or more Hall sensor active areas is disposed in a rather tiny volume of a few µm³ which effectively means that all Hall sensor active areas yield through averaging field measurements at the same place simultaneously.

In a preferred embodiment of the present invention, the support parts are formed as truncated pyramids wherein each Hall sensor is disposed on the peak of a pyramidal support part. This design allow to concentrate diverse Hall sensor active areas directly adjacent to each other wherein the support part may have a design to offer a reference surface when positioning the Hall sensor assembly for rotating the Hall sensor assembly during calibration as well as for the positioning when measuring. Preferably, the pyramidal support parts represent a cube when assembled. Said pyramidal support then comprise a square ground area and angle of 45° and 90° in the peak of the pyramid.

In order to provide an accuracy in the range of better than 10⁻³ the Hall sensor active area as well as the sensor substrate can be made from a semiconductor material, preferably GaAs, and the four contact lines are made from a highly conducting material, preferably from gold.

In order to support the accuracy of the measurements, it is important that the surrounding materials do not distort the magnetic field to be measured. Therefore, a preferred choice may provide for support parts that are made from a non-conducting and non-magnetic material, preferably from crystal (i.e. sapphire) or a ceramics or from a composite material.

During manufacturing after the assembly of the Hall sensor active area and the sensor substrate on the support part, the smoothing can be preferably performed by an abrasive method, such as laser cutting, laser grinding or the like.

In order to provide for a preferred solution for the contacting of the four contact lines of the Hall sensor active area (which itself comprises four terminal areas for its contact to the contact lines), it is advantageous when the surfaces of the support parts are at least partially coated with a conductive layer; said conductive layer being separated into four sections; each section being connected to one of the four contact lines. Preferably, the support parts are at least partially coated with gold. Of course, the conductive layer is coated with an insulating layer prior to the assembling of the support parts in order to separate the contact lines from one Hall sensor to the other. This insulating layer may be rendered obsolete by spacing the support parts when assembling. The isolation among the different conductive layer is then achieved either just by the air gap or an additional insulation material filling the gaps.

For the accuracy of the Hall sensor assembly, the calibration has to be performed properly. In order to enable for a sufficient calibration, it is advantageous when at least one of the support parts comprises a reference surface enabling the positioning of the Hall sensor assembly for a rotation during calibration of the Hall sensor assembly.

As already mentioned earlier, a preferred design of the Hall sensor assembly provides for the support parts to be formed as truncated pyramids wherein the Hall sensor active areas are disposed with its sensor substrate on the upper surface of the truncated pyramids. Preferably, six pyramids having a square ground area are assembled to form a cube wherein the Hall sensor active areas are all located in the spatial center of the cube.

Preferred examples of the present invention are hereinafter explained in more detail with references to the attached drawings which depict in:
- Figure 1: a planar Hall sensor comprising a Hall sensor active area and a substrate;
- Figure 2: the planar Hall sensor mounted onto a truncated support pyramid;
- Figure 3: the planar Hall sensor on the truncated support pyramid with Ohmic contacts; and
- Figure 4: the assembly of six pyramids to form an internal spatially centered cube with six Hall sensor active areas, two for each direction of the Cartesian system.

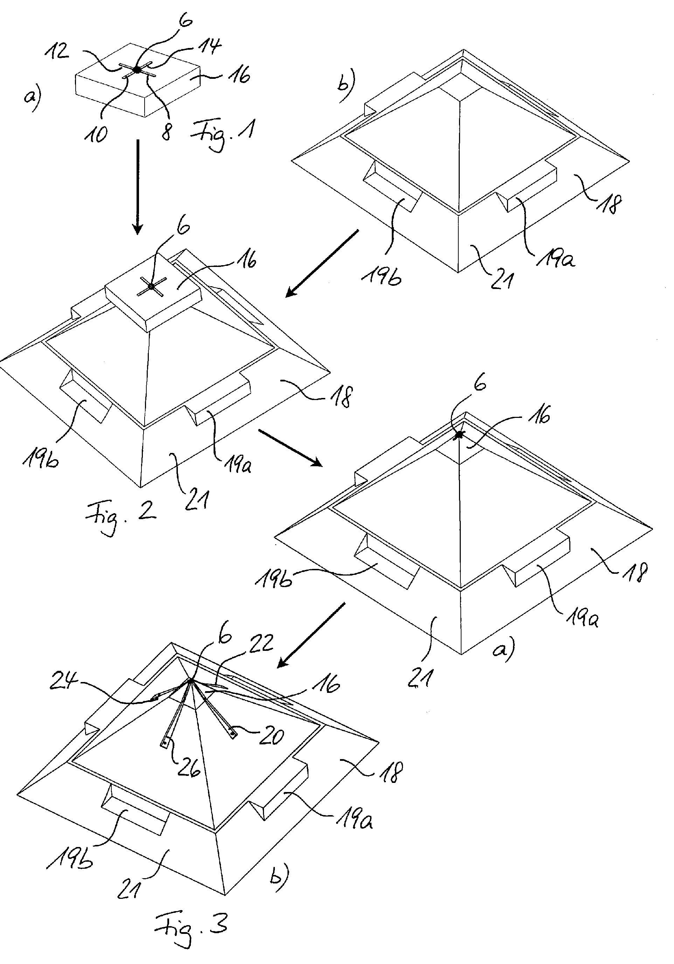

The preferred example of the present invention presents a design of a Hall sensor assembly cube 2 of a few mm in size, made in such a way to form in the spatial centre 4 of the cube an inner cube of sub-millimeter dimension with a Hall sensor active area on each of its surfaces. As shown in Figure 1, a semiconductor Hall sensor active area 6 (GaAs) has four electrical connections 8 to 14 (made from gold), two connections for the driving current (AC or DC) and two connections for the output voltage signal. The Hall sensor active area 6 and the electrical connections 8 to 14 build a Hall element disposed on a semiconductor sensor substrate 16 made from GaAs, too. In the present example, the Hall sensor active area 6 is epitaxially grown on the sensor substrate 16.

The semiconductor sensor substrate 16 is in the present example mounted to a truncated pyramid support part 18 made from a crystal or a ceramic or a composite material. In the present example synthetic sapphire has been used as shown in Figure 2.

In Figure 3, the situation is shown after the smoothening of the passage from the semiconductor sensor substrate 16 to the truncated pyramid support part 18. The contact lines 8 to 14 are each connected with gold layers 20 to 26 deposited on parts of the surfaces of the pyramid support part 18. Of course, the gold layers 20 to 26 may be coated with an insulator layer in order to separate each contact line 8 to 14 and its respective gold layer 20 to 26 from each other. In the present example, the supports parts 18 are be spaced relatively to each other when assembled by spacer elements 19a, 19b that are formed in the lower part 21 of the truncated pyramid support part 18. Grace to the spacer elements 19a, 19b in the assembly an insulation of the gold layers 20 to 26 is resulting by air gap. Alternatively, an insulation material can be filled into the air gap.

The point illustrated in each gold layer 20 to 26 shall represent the connection to a control electronics (not shown) which usually resides apart from the truncated pyramid support part 18.

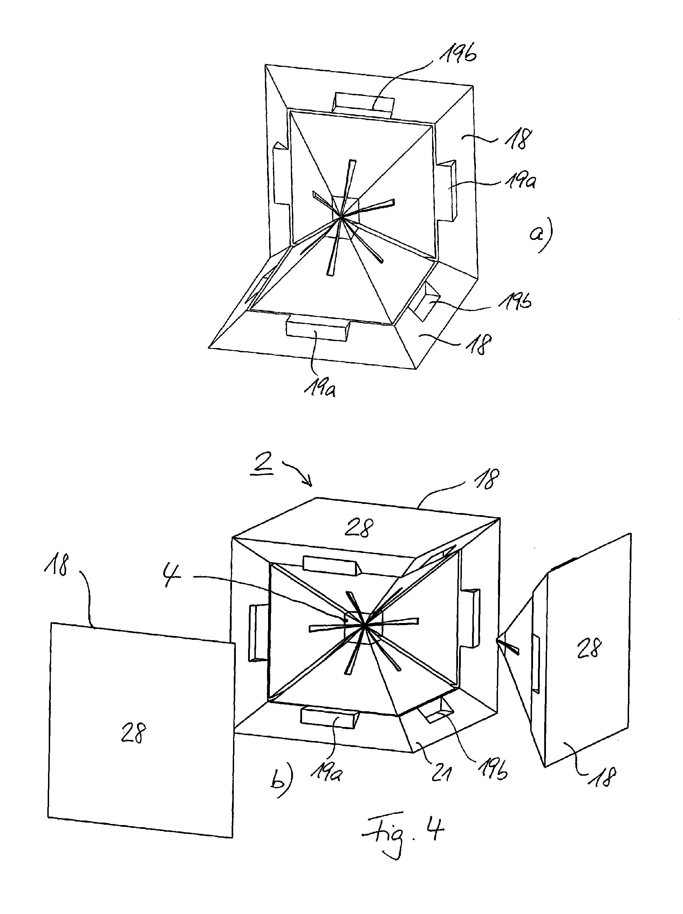

As shown in Figure 4, the geometry of the cube 2 is presently obtained by a precise assembly of six truncated pyramids 18. The miniature size and the geometrical precision of the epitaxially grown semiconductor Hall sensors active areas 6 are superior to the classical approach of gluing commercially available Hall sensors. The large benefit is the possibility of achieving a small distance (<0.1 mm) between two Hall sensor active areas 6 for each direction of the Cartesian system thus considerably reducing the errors stemming from averaging of the measured values from opposing surfaces of the Hall sensor active volume in magnetic fields with a nonlinear distribution, like in sextupoles and higher multipole magnets or in fringe fields. The three pairs (three groups) of Hall elements from the opposite cube surfaces are each sensitive to the same magnetic field direction, in the present example a pair per field component. In the present example, the center 4 of the cube 2 with six Hall sensors has a size of less than (0.1 mm)³. The flat square ground area 28 of each pyramid 18 serves as a reference surface in order to precisely position the Hall sensor assembly cube 2 during the rotation of the Hall sensor assembly cube 2 for the purpose of its calibration as well as for the purpose of the precise positioning during measurements.

Alternatively to the pyramidal support parts 18, the Hall sensor assembly may comprise a holder member, such as a glass cube, that comprises a number of bore holes, such as conical bore holes each tapering versus the center of the holder member. The support parts themselves will also have a conical shape accordingly with the Hall sensor active area and the Hall sensor substrate being located at the tip of the conical support part.

The advantages of this chosen geometry are:
■ the use of highly accurate planar Hall sensor active areas;
■ double readings for each field component resulting to an improved accuracy;
■ the averaged values of all three field components are assigned to the same point in space, at the centre 4 of the Hall sensor assembly cube 2, thus allowing for instantaneous measurements of the full field vector;
■ with the appropriate electrical connections of the Hall sensor active areas from opposing surfaces of each pair, the undesired planar Hall effect can be practically cancelled out.

## Claims

1. Hall sensor assembly (2), comprising a number of Hall sensors (6), each being disposed on a non-conducting, non-magnetic support part (18); wherein the support parts (18) are formed to support the formation of three groups of Hall sensors, each group covering the measurement of the magnetic field for one of the three Cartesian directions wherein the three groups of Hall sensors are disposed adjacent to each other in order to share a common Hall sensor active volume (4) .

2. Hall sensor assembly (2) according to claim 1 wherein the support parts (18) are formed as truncated pyramids wherein each Hall sensor (6) is disposed on the peak of a pyramidal support part (18).

3. Hall sensor assembly (2) according to claim 2 wherein the pyramidal support parts (18) represent a cube when assembled.

4. A method for manufacturing a Hall sensor assembly (2), comprising the steps of:
a) depositing a Hall sensor active area (6) on a substrate (16);
b) contacting the Hall sensor active area (6) with four contact lines (8 to 14) being hosted on the sensor substrate (16);
c) mounting the sensor substrate (16) to a support part (18);
d) optionally smoothing the passage from the sensor substrate (16) and the support part (18);
e) extending the four contact line (8 to 14) along the support part (18);
f) assembling a number of support parts (18) manufactured according to the step a) to e) in order to form three groups of Hall sensors, each group covering the measurement of the magnetic field for one of the three Cartesian directions wherein the three groups of Hall sensors are disposed adjacent to each other in order to share a common Hall sensor active volume (4).

5. The method according to claim 4 wherein the Hall sensor active area (6) as well as the sensor substrate (16) are made from a semiconductor material, preferably GaAs, and the four contact lines (8 to 14) are made from a high conducting material, preferably from gold.

6. The method according to claim 4 or 5, wherein the support parts (18) are made from a non-conducting and non-magnetic material, preferably from crystal or ceramics or from a composite material.

7. The method according to any of the preceding claims 4 to 6, wherein the smoothing is performed by an abrasive method, such as laser cutting, laser grinding or the like.

8. The method according to any of the preceding claims 4 to 7, wherein the surfaces of the support parts (18) are at least partially coated with a conductive layer (20 to 26); said conductive layer being (20 to 26) separated into four sections; each section being connected to one of the four contact lines (8 to 14).

9. The method according to claim 8, wherein the support parts (18) are at least partially coated with gold.

10. The method according to claim 8 or 9, wherein the conductive layer is coated with insulating layer prior to the assembling of the support parts (18).

11. The method according to any of the preceding claims 4 to 10, wherein at least one of the support parts (18) comprises a reference surface (28) enabling the positioning for a rotation during calibration of the Hall sensor assembly (2).

12. The method according to any of the preceding claims 4 to 11, wherein the support parts (18) are formed as truncated pyramids wherein the Hall sensor active areas (6) are disposed with its sensor substrate (16) on the upper surface of the truncated pyramids.

13. The method according to claim 12, wherein six pyramids having a square ground area are assembled to form a cube (2) wherein the Hall sensor active areas (6) are all located in the spatial center (4) of the cube (2).
